(19) **Europäisches Patentamt / European Patent Office / Office européen des brevets**

(11) **EP 2 584 070 B1**

(12) **EUROPEAN PATENT SPECIFICATION**

(45) Date of publication and mention
of the grant of the patent:
**19.07.2017 Bulletin 2017/29**

(51) Int Cl.:
***C30B 15/00*** *(2006.01)* ***C30B 29/06*** *(2006.01)*

(21) Application number: **12187556.1**

(22) Date of filing: **08.10.2012**

(54) **METHOD OF MANUFACTORING A P-TYPE SILICON SINGLE CRYSTAL**

VERFAHREN ZUR HERSTELLUNG VON P-TYP-SILICIUMEINKRISTALL

PROCÉDÉ DE FABRICATION D'UN MONOCRISTAL DE SILICIUM DE TYPE P

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **17.10.2011 JP 2011227861**

(43) Date of publication of application:
**24.04.2013 Bulletin 2013/17**

(73) Proprietor: **Siltronic AG
81737 München (DE)**

(72) Inventor: **Nakai, Katsuhiko
Hikari,
Yamaguchi 743-0071 (JP)**

(56) References cited:
**WO-A1-2009/003183      FR-A1- 2 929 960
JP-A- 2004 307 305      US-A1- 2007 056 504**

## Description

### Technical Field

The present invention relates to a p-type silicon single crystal and a method of manufacturing the same, and particularly to a p-type silicon single crystal manufactured with a Czochralski method and a method of manufacturing the same.

### Background Art

A power device such as an IGBT (Insulated Gate Bipolar Transistor) has recently widely been used in home appliances, industrial machines, and the like. One of primary characteristics of the power device is a high withstand voltage, and a substrate used for a power device in order to achieve this is required to be high in resistivity and less in variation thereof.

A silicon single crystal used for a substrate for a power device is manufactured mainly with a Czochralski method (a CZ method). With this CZ method, since a segregation coefficient of such dopants as boron and phosphorus with respect to a silicon single crystal is smaller than 1, dopant concentration in a silicon melt becomes high as the silicon single crystal grows. Therefore, the dopant concentration in the grown silicon single crystal varies in a direction of an axis of growth, and consequently, resistivity of the silicon single crystal varies in the direction of the axis of growth. Thus, it has been difficult to control resistivity.

Regarding a technique for controlling resistivity of a single crystal, for example, Japanese National Patent Publication No. 2010-531805 (Patent Document 1) describes a method of controlling resistivity of a silicon ingot used for manufacturing a solar cell. With this method, a silicon ingot is formed by preparing a metallurgical-grade silicon source material containing boron and phosphorus and adding aluminum or the like to metallurgical-grade silicon to fabricate a silicon melt.

### Problems to be Solved by the Invention

In the method described in Patent Document 1, metallurgical-grade silicon containing a large amount of impurities is used as a silicon source material. Therefore, a resultant silicon single crystal substrate has resistivity as low as approximately 5 $\Omega$cm or lower and it has been difficult to employ such a substrate for a power device required to be in high in withstand voltage.

In addition, in the metallurgical-grade silicon source material above, boron and phosphorus are originally dissolved in the silicon source material. Then, an amount of boron and phosphorus is determined and a group III element is mainly added in accordance with the amount of boron and phosphorus. Thus, since one type of element is simply mainly used as an element for controlling resistivity, it has virtually been difficult to lessen variation in resistivity of the silicon single crystal substrate.

The present invention was made in view of the above-described problems, and an object thereof is to provide a p-type silicon single crystal high in resistivity and less in variation in resistivity and a method of manufacturing the same.

### Means for Solving the Problems

A method of manufacturing a p-type silicon single crystal according to the present invention is given in claim 1 and has the following steps. A silicon melt to which boron as a main dopant, a first sub dopant which is an n-type impurity and smaller in segregation coefficient than boron, and a second sub dopant which is a p-type impurity and smaller in segregation coefficient than the first sub dopant have been added, is prepared. A silicon single crystal having resistivity not lower than 6 $\Omega$cm is grown from the silicon melt with a Czochralski method. Here, the segregation coefficient refers to a segregation coefficient with respect to a silicon single crystal.

By thus using a plurality of sub dopants, a p-type silicon single crystal high in resistivity and less in variation in resistivity can be obtained.

In the method of manufacturing a p-type silicon single crystal above, preferably, the first sub dopant is phosphorus and the second sub dopant is aluminum. A first concentration ratio calculated by dividing concentration of the first sub dopant in the silicon melt by concentration of the main dopant in the silicon melt is not lower than 0.5 and not higher than 1.2. A second concentration ratio calculated by dividing concentration of the second sub dopant in the silicon melt by concentration of the main dopant in the silicon melt is not lower than 4.9 and not higher than 52.4. Here, the concentration in the silicon melt refers to concentration in an initial silicon melt before growth of the silicon single crystal.

In the method of manufacturing a p-type silicon single crystal above, preferably, the first sub dopant is phosphorus and the second sub dopant is gallium. A first concentration ratio calculated by dividing concentration of the first sub dopant in the silicon melt by concentration of the main dopant in the silicon melt is not lower than 0.5 and not higher than 1.2. A second concentration ratio calculated by dividing concentration of the second sub dopant in the silicon melt by concentration of the main dopant in the silicon melt is not lower than 1.2 and not higher than 13.4.

In the method of manufacturing a p-type silicon single crystal above, preferably, the first sub dopant is phosphorus and the second sub dopant is indium. A first concentration ratio calculated by dividing concentration of the first sub dopant in the silicon melt by concentration of the main dopant in the silicon melt is not lower than 0.5 and not higher than 1.2. A second concentration ratio calculated by dividing concentration of the second sub dopant in the silicon melt by concentration of the main dopant in the silicon melt is not lower than 25.1 and not higher than 261.2.

In the method of manufacturing a p-type silicon single crystal above, preferably, the first sub dopant is arsenic and the second sub dopant is aluminum. A first concentration ratio calculated by dividing concentration of the first sub dopant in the silicon melt by concentration of the main dopant in the silicon melt is not lower than 0.6 and not higher than 1.5. A second concentration ratio calculated by dividing concentration of the second sub dopant in the silicon melt by concentration of the main dopant in the silicon melt is not lower than 11.7 and not higher than 72.2.

In the method of manufacturing a p-type silicon single crystal above, preferably, the first sub dopant is arsenic and the second sub dopant is gallium. A first concentration ratio calculated by dividing concentration of the first sub dopant in the silicon melt by concentration of the main dopant in the silicon melt is not lower than 0.6 and not higher than 1.5. A second concentration ratio calculated by dividing concentration of the second sub dopant in the silicon melt by concentration of the main dopant in the silicon melt is not lower than 3.1 and not higher than 18.3.

In the method of manufacturing a p-type silicon single crystal above, preferably, the first sub dopant is arsenic and the second sub dopant is indium. A first concentration ratio calculated by dividing concentration of the first sub dopant in the silicon melt by concentration of the main dopant in the silicon melt is not lower than 0.6 and not higher than 1.4. A second concentration ratio calculated by dividing concentration of the second sub dopant in the silicon melt by concentration of the main dopant in the silicon melt is not lower than 57.9 and not higher than 324.0.

In the method of manufacturing a p-type silicon single crystal above, preferably, the first sub dopant is phosphorus and the second sub dopant is aluminum. A first concentration ratio calculated by dividing concentration of the first sub dopant in the silicon melt by concentration of the main dopant in the silicon melt is not lower than 0.79 and not higher than 0.81. A second concentration ratio calculated by dividing concentration of the second sub dopant in the silicon melt by concentration of the main dopant in the silicon melt is not lower than 24.2 and not higher than 27.0.

In the method of manufacturing a p-type silicon single crystal above, preferably, the first sub dopant is phosphorus and the second sub dopant is aluminum. A first concentration ratio calculated by dividing concentration of the first sub dopant in the silicon melt by concentration of the main dopant in the silicon melt is not lower than 0.89 and not higher than 0.91. A second concentration ratio calculated by dividing concentration of the second sub dopant in the silicon melt by concentration of the main dopant in the silicon melt is not lower than 30.8 and not higher than 33.8.

In the method of manufacturing a p-type silicon single crystal above, preferably, the first sub dopant is phosphorus and the second sub dopant is gallium. A first concentration ratio calculated by dividing concentration of the first sub dopant in the silicon melt by concentration of the main dopant in the silicon melt is not lower than 0.79 and not higher than 0.81, and a second concentration ratio calculated by dividing concentration of the second sub dopant in the silicon melt by concentration of the main dopant in the silicon melt is not lower than 6.2 and not higher than 6.9.

In the method of manufacturing a p-type silicon single crystal above, preferably, the first sub dopant is phosphorus and the second sub dopant is gallium. A first concentration ratio calculated by dividing concentration of the first sub dopant in the silicon melt by concentration of the main dopant in the silicon melt is not lower than 0.89 and not higher than 0.91.

A second concentration ratio calculated by dividing concentration of the second sub dopant in the silicon melt by concentration of the main dopant in the silicon melt is not lower than 7.8 and not higher than 8.5.

**Effects of the Invention**

According to the present invention, a p-type silicon single crystal high in resistivity and less in variation in resistivity can be obtained.

**Brief Description of the Drawings**

Fig. 1 is a schematic construction diagram showing an apparatus for manufacturing a p-type silicon single crystal in the present embodiment.

Fig. 2 is a flowchart showing a method of manufacturing a p-type silicon single crystal in the present embodiment.

Fig. 3 is a diagram showing relation between resistivity and a solidified fraction of a p-type silicon single crystal.

**Modes for Carrying Out the Invention**

An embodiment of the present invention will be described hereinafter with reference to the drawings. It is noted that the same or corresponding elements in the drawings below have the same reference numerals allotted and description thereof will not be repeated.

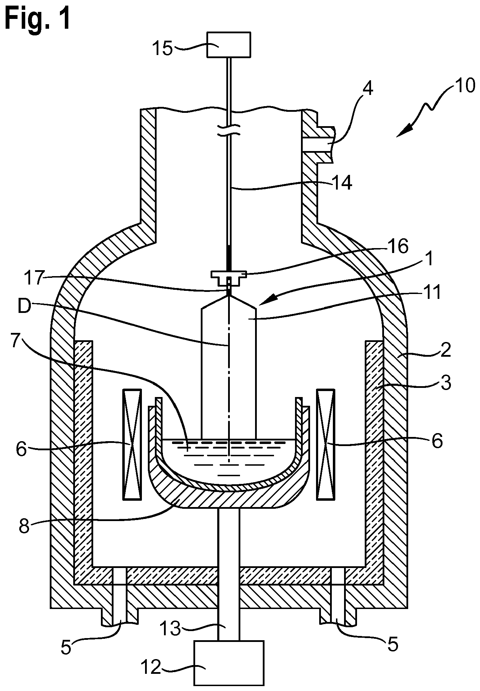

Initially, a manufacturing apparatus for manufacturing a p-type silicon single crystal in the present embodiment will be described with reference to Fig. 1.

As shown in Fig. 1, a silicon single crystal manufacturing apparatus 10 mainly has a chamber 2, a heater 6, a crucible 8, a crucible support shaft 13, and a pull-up wire 14. A heat insulator 3 is provided on an inner wall of chamber 2. A gas supply port 4 for introducing an inert gas such as argon (Ar) is provided in an upper portion of chamber 2, and an exhaust port 5 for exhausting a gas in chamber 2 is provided in a bottom portion of chamber 2. Crucible 8 is filled with a doped silicon melt 7 . Heater 6 is provided around crucible 8, and silicon melt 7 can be fabricated by melting a silicon source material. Crucible support shaft 13 extends from a lower end portion of crucible 8 to the bottom portion of the chamber and it is rotatably supported by a crucible support shaft drive device 12. Pull-up wire 14 serves to pull up a silicon single crystal 1 and it is vertically movable by a pull-up wire drive device 15.

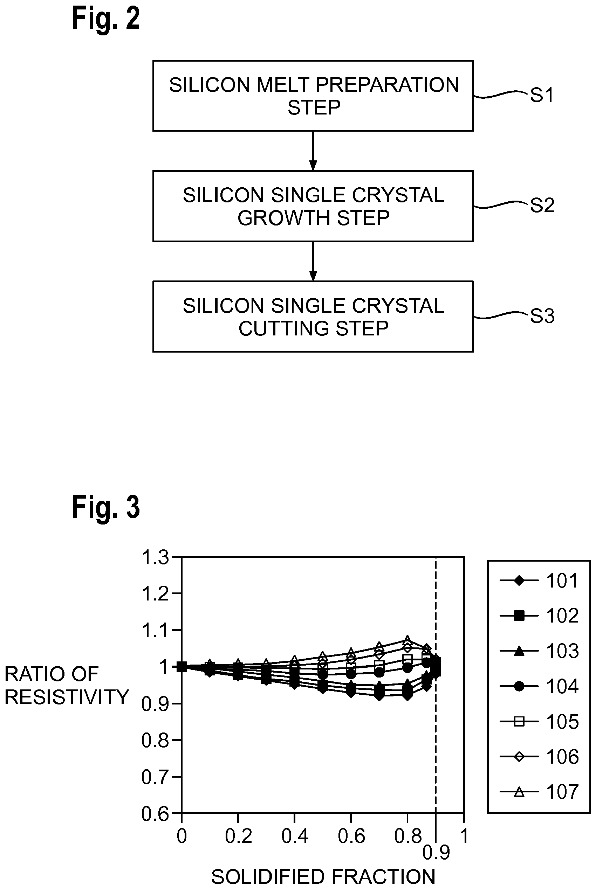

A method of manufacturing a p-type silicon single crystal in the present embodiment will now be described with reference to Figs. 1 and 2.

As shown in Fig. 2, the p-type silicon single crystal according to the present embodiment serves to manufacture a silicon single crystal with a Czochralski method, and mainly has a silicon melt preparation step S1, a silicon single crystal growth step S2, and a silicon single crystal cutting step S3.

In silicon melt preparation step S1, crucible 8 is filled with a silicon source material and heated by heater 6, so that the silicon source material is molten. Three types of dopants of a main dopant, a first sub dopant, and a second sub dopant are added to dope the silicon melt. The main dopant is boron representing a p-type impurity. The first sub dopant is an impurity having an n conductivity type and being smaller in segregation coefficient with respect to the silicon single crystal than boron (B) which is the main dopant. The first sub dopant is a group V element such as phosphorus (P) and arsenic (As). The second sub dopant is an impurity having a p conductivity type and being smaller in segregation coefficient with respect to the silicon single crystal than the first sub dopant. The second sub dopant is a group III element such as aluminum (Al), gallium (Ga), and indium (In).

In the present embodiment, semiconductor-grade silicon is employed as the silicon source material. Semiconductor-grade silicon has a lower impurity concentration and is higher in purity than metallurgical-grade silicon. Semiconductor-grade silicon has silicon purity, for example, of 99.999999999% (11N).

The main dopant, the first sub dopant, and the second sub dopant to be added to the silicon source material may be added to the silicon melt all at once or separately. For example, initially, the main dopant may be added to silicon melt 7, followed by the first sub dopant and then the second sub dopant.

In silicon single crystal growth step S2, initially, a seed crystal 17 attached to a seed chuck 16 is brought down to a surface of silicon melt 7 and immersed therein. Thereafter, pull-up wire 14 is wound up by pull-up wire drive device 15 to thereby pull up silicon single crystal 1.

After silicon single crystal 1 undergoes growth of a conical portion (an expanded portion) and grows to a target diameter, a straight part of ingot 11 is grown to a prescribed length.

In silicon single crystal cutting step S3, initially, straight part of ingot 11 is grown to the prescribed length, and thereafter wind-up of pull-up wire 14 is stopped. Thereafter, by lowering crucible 8, silicon single crystal 1 is separated from silicon melt 7. By slicing silicon single crystal 1 along a plane perpendicular to the direction of axis of growth of silicon single crystal 1, a silicon wafer is obtained.

A result of simulation of relation between resistivity and a solidified fraction of a silicon single crystal will now be described with reference to Fig. 3.

The abscissa in Fig. 3 represents a solidified fraction. The solidified fraction refers to a ratio of a mass of crystallized silicon with respect to the total mass of source material silicon contained in the silicon melt. The ordinate in Fig. 3 represents a ratio of resistivity in a direction of an axis of growth D of silicon single crystal 1. Here, resistivity is resistivity at the center (that is, the axis of growth) of the silicon single crystal. In addition, a ratio of resistivity refers to a value calculated by standardizing resistivity at a certain solidified fraction with resistivity at a solidified fraction of 0.

In Fig. 3, samples 101 to 107 each represent a p-type silicon single crystal formed with the Czochralski method from the silicon melt, to which boron, phosphorus, and aluminum have been added as the main dopant, the first sub dopant, and the second sub dopant, respectively.

Boron concentrations in the silicon melts for samples 101 to 107 are $3.2 \times 10^{15}$ atoms/cm$^3$ (101), $1.1 \times 10^{15}$ atoms/cm$^3$ (102), $1.2 \times 10^{15}$ atoms/cm$^3$ (103), $2.6 \times 10^{14}$ atoms/cm$^3$ (104), $2.1 \times 10^{14}$ atoms/cm$^3$ (105), $1.9 \times 10^{14}$ atoms/cm$^3$ (106), and $2.0 \times 10^{14}$ atoms/cm$^3$ (107), respectively.

Concentration ratios (first concentration ratios) calculated by dividing phosphorus concentrations in the silicon melts for samples 101 to 107 by boron concentrations are 0.50 (101), 0.60 (102), 0.70 (103), 0.90 (104), 1.00 (105), 1.10 (106), and 1.20 (107), respectively.

Concentration ratios (second concentration ratios) calculated by dividing aluminum concentrations in the silicon melts for samples 101 to 107 by boron concentrations are 5.60 (101), 11.70 (102), 18.50 (103), 31.76 (104), 38.65 (105), 45.06 (106), and 52.40 (107), respectively.

As can be seen in Fig. 3, in a range of the solidified fraction from 0 to 0.9, variation in resistivity in the direction of axis of growth of silicon single crystal samples 101 to 107 is very low, that is, approximately from 3 to 8% or lower. It is noted that variation in resistivity is a value defined by Equation 1. Here, a maximum value of resistivity is a maximum value of resistivity of the silicon single crystal in the direction of axis of growth, and a minimum value of resistivity is a minimum value of resistivity of the silicon single crystal in the direction of axis of growth.

Equation 1

$$\text{Variation in Resistivity} = \frac{(\text{Maximum Value of Resistivity} - \text{Minimum Value of Resistivity})}{\text{Maximum Value of Resistivity}} \times 100$$

A substrate used for a power device such as an IGBT is required to be high in resistivity and less in variation in resistivity. Specifically, resistivity of the p-type silicon single crystal is desirably not lower than 6 $\Omega$cm, preferably not lower than 50 $\Omega$cm, and further preferably not lower than 100 $\Omega$cm. In addition, variation in resistivity of the p-type silicon single crystal is desirably not higher than 20%, preferably not higher than 15%, more preferably not higher than 8%, and further preferably not higher than 5%.

A mechanism with which variation in resistivity of the silicon single crystal in the present embodiment becomes less will now be described.

In a case where only boron (the main dopant) is added to the silicon melt, boron concentration in the silicon single crystal becomes higher as the silicon single crystal grows (that is, the solidified fraction becomes greater). Therefore, resistivity becomes lower on a bottom side of the silicon single crystal.

The reason is as follows. Boron concentration in the silicon melt increases as the silicon single crystal grows, because boron has a segregation coefficient with respect to the silicon single crystal around 0.78, which is lower than 1. Consequently, a ratio of boron taken into the silicon single crystal becomes higher and resistivity becomes lower.

Similarly in a case where phosphorus is added to the silicon melt as well, phosphorus concentration in the silicon single crystal becomes higher as the silicon single crystal grows. Therefore, resistivity becomes lower on the bottom side of the silicon single crystal. Phosphorus has a segregation coefficient with respect to the silicon single crystal around 0.38, which is lower than that of boron. Therefore, a rate of condensation of phosphorus in the silicon melt with growth of the silicon single crystal is greater than a rate of condensation of boron. Thus, a rate of lowering in resistivity with growth of the silicon single crystal is also greater in a case where phosphorus is added than in a case where boron is added.

In a case where boron (the main dopant) and phosphorus (the first sub dopant) are added to the silicon melt, carriers that are produced and opposite in conductivity type cancel each other, because boron represents a p-type impurity and phosphorus represents an n-type impurity. Therefore, by adding phosphorus together with boron to the silicon single crystal, density of p-type carriers can be lowered and resistivity can be increased. In addition, a rate of increase in impurity concentration with growth of the silicon single crystal is greater in a case where phosphorus is added than in a case where boron is added. Therefore, a rate of lowering in resistivity with growth of the silicon single crystal can be lowered by canceling increase in p-type carrier density owing to increase in boron concentration with growth of the silicon single crystal, with increase in n-type carrier density owing to increase in phosphorus concentration.

When the solidified fraction is small, a rate of lowering in resistivity with growth of the silicon single crystal can be lowered. When the solidified fraction becomes greater, however, increase in n-type carrier density owing to increase in phosphorus concentration prevails and resistivity becomes higher as the silicon single crystal grows.

In a case where aluminum (the second sub dopant) smaller in segregation coefficient than phosphorus (the first sub dopant) is added to the silicon melt, substantially no p-type carriers produced by aluminum are taken into the silicon single crystal when the solidified fraction is small. When the solidified fraction becomes greater, however, aluminum is gradually taken into the silicon single crystal and p-type carriers increase. Consequently, resistivity gradually becomes lower. Therefore, addition of aluminum can suppress increase in resistivity of the silicon single crystal when the solidified fraction is great. Consequently, variation in resistivity in the direction of axis of growth of the silicon single crystal can be lessened.

Thus, the first sub dopant which is an n-type impurity and smaller in segregation coefficient than the main dopant can suppress change in resistivity of the silicon single crystal when the solidified fraction is small, and the second sub dopant which is a p-type impurity and smaller in segregation coefficient than the first sub dopant can suppress change in resistivity of the silicon single crystal when the solidified fraction is great.

First Embodiment

Table 1

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | P/B | Al/B | Range of Solidified Fraction: 0-0.9 | | |
| $3.03 \times 10^{15}$ | 0.40 | 1.1 | 7.0 | 6.2 | 11.0 |
| $3.18 \times 10^{15}$ | 0.50 | 4.5 | 7.1 | 6.5 | 8.5 |
| $3.18 \times 10^{15}$ | 0.50 | 4.9 | 7.0 | 6.5 | 7.7 |
| $3.17 \times 10^{15}$ | 0.50 | 5.6 | 7.0 | 6.5 | 7.8 |
| $3.17 \times 10^{15}$ | 0.50 | 6.0 | 7.0 | 6.4 | 8.0 |
| $2.31 \times 10^{15}$ | 0.60 | 10.5 | 10.4 | 9.5 | 9.0 |
| $2.30 \times 10^{15}$ | 0.60 | 11.0 | 10.2 | 9.4 | 7.9 |
| $1.14 \times 10^{15}$ | 0.60 | 11.7 | 20.0 | 18.8 | 6.4 |
| $1.13 \times 10^{15}$ | 0.60 | 13.0 | 20.0 | 18.6 | 7.1 |
| $1.13 \times 10^{15}$ | 0.60 | 13.8 | 20.0 | 18.4 | 8.0 |
| $1.20 \times 10^{15}$ | 0.70 | 16.0 | 21.7 | 19.3 | 11.2 |
| $1.19 \times 10^{15}$ | 0.70 | 17.3 | 20.8 | 19.2 | 7.7 |
| $1.19 \times 10^{15}$ | 0.70 | 18.5 | 20.0 | 19.0 | 4.8 |
| $7.80 \times 10^{14}$ | 0.70 | 21.2 | 30.0 | 27.7 | 7.8 |
| $4.64 \times 10^{14}$ | 0.70 | 23.0 | 50.0 | 43.8 | 12.4 |
| $4.98 \times 10^{14}$ | 0.80 | 22.0 | 56.2 | 49.0 | 12.7 |
| $4.95 \times 10^{14}$ | 0.80 | 23.6 | 52.9 | 48.8 | 7.9 |
| $4.92 \times 10^{14}$ | 0.80 | 25.2 | 50.1 | 48.3 | 3.5 |
| $4.89 \times 10^{14}$ | 0.80 | 26.8 | 50.0 | 47.6 | 4.9 |
| $4.87 \times 10^{14}$ | 0.80 | 27.8 | 50.0 | 46.1 | 7.8 |
| $2.42 \times 10^{14}$ | 0.80 | 29.0 | 100.0 | 89.0 | 11.0 |
| $1.19 \times 10^{15}$ | 0.79 | 24.2 | 21.0 | 20.0 | 4.5 |
| $1.19 \times 10^{15}$ | 0.81 | 24.2 | 22.4 | 20.6 | 8.0 |
| $7.80 \times 10^{14}$ | 0.79 | 27.0 | 31.2 | 28.9 | 7.4 |
| $4.64 \times 10^{14}$ | 0.81 | 27.0 | 53.0 | 51.0 | 3.9 |
| $2.60 \times 10^{14}$ | 0.90 | 29.0 | 111.9 | 99.0 | 11.5 |
| $2.58 \times 10^{14}$ | 0.90 | 30.1 | 107.2 | 98.8 | 7.8 |
| $2.57 \times 10^{14}$ | 0.90 | 31.8 | 101.2 | 98.2 | 3.0 |
| $2.55 \times 10^{14}$ | 0.90 | 33.5 | 100.0 | 95.0 | 5.0 |
| $2.54 \times 10^{14}$ | 0.90 | 34.4 | 100.0 | 92.3 | 7.7 |

(continued)

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | P/B | Al/B | Range of Solidified Fraction: 0-0.9 | | |
| $1.94\times10^{14}$ | 0.90 | 36.0 | 130.0 | 114.3 | 12.1 |
| $1.94\times10^{14}$ | 0.89 | 30.8 | 134.1 | 129.3 | 3.6 |
| $1.94\times10^{14}$ | 0.91 | 30.8 | 143.1 | 132.1 | 7.7 |
| $1.94\times10^{14}$ | 0.89 | 33.8 | 130.2 | 119.9 | 7.9 |
| $1.94\times10^{14}$ | 0.91 | 33.8 | 132.1 | 127.1 | 3.8 |
| $2.11\times10^{14}$ | 1.00 | 34.0 | 158.0 | 129.9 | 17.8 |
| $2.08\times10^{14}$ | 1.00 | 36.7 | 140.8 | 129.5 | 8.0 |
| $2.07\times10^{14}$ | 1.00 | 38.7 | 133.0 | 129.0 | 3.0 |
| $2.06\times10^{14}$ | 1.00 | 40.1 | 130.0 | 123.9 | 4.7 |
| $2.05\times10^{14}$ | 1.00 | 41.0 | 130.0 | 120.2 | 7.6 |
| $1.76\times10^{14}$ | 1.00 | 43.0 | 150.0 | 130.1 | 13.3 |
| $1.90\times10^{14}$ | 1.10 | 43.0 | 168.3 | 150.0 | 10.9 |
| $1.88\times10^{14}$ | 1.10 | 45.1 | 158.3 | 149.9 | 5.3 |
| $1.87\times10^{14}$ | 1.10 | 47.2 | 152.5 | 141.0 | 7.5 |
| $1.87\times10^{14}$ | 1.10 | 47.5 | 151.6 | 139.3 | 8.1 |
| $1.99\times10^{14}$ | 1.20 | 51.9 | 163.0 | 150.0 | 8.0 |
| $1.98\times10^{14}$ | 1.20 | 52.4 | 161.3 | 149.0 | 7.6 |
| $2.09\times10^{14}$ | 1.30 | 59.1 | 167.0 | 149.3 | 10.6 |

Table 1 shows results of simulation of a maximum value and a minimum value of resistivity and variation in resistivity in a direction of an axis-of-growth line of the silicon single crystals when a value calculated by dividing concentration of the first sub dopant in the silicon melt by concentration of the main dopant in the silicon melt (the first concentration ratio) is varied in a range approximately not lower than 0.4 and approximately not higher than 1.3 and a value calculated by dividing concentration of the second sub dopant in the silicon melt by concentration of the main dopant in the silicon melt (the second concentration ratio) is varied in a range approximately not lower than 1.1 and approximately not higher than 59.1 in a case where boron (B), phosphorus (P), and aluminum (Al) are employed as the main dopant, the first sub dopant, and the second sub dopant to be added to the silicon melt, respectively. Boron concentration in this case is approximately not lower than $1.87 \times 10^{14}$ atoms/cm$^3$ and approximately not higher than $3.18 \times 10^{15}$ atoms/cm$^3$.

In this case, a p-type silicon single crystal of which maximum value of resistivity is approximately not lower than 7.0 $\Omega$cm and approximately not higher than 168.3 $\Omega$cm, minimum value of resistivity is approximately not lower than 6.2 $\Omega$cm and approximately not higher than 150.0 $\Omega$cm, and variation in resistivity in the direction of axis of growth is approximately not higher than 17.8% can be obtained.

More preferably, a value calculated by dividing concentration of the first sub dopant in the silicon melt by concentration of the main dopant in the silicon melt (the first concentration ratio) is in a range approximately not lower than 0.5 and approximately not higher than 1.2 and a value calculated by dividing concentration of the second sub dopant in the silicon melt by concentration of the main dopant in the silicon melt (the second concentration ratio) is in a range approximately not lower than 4.9 and approximately not higher than 52.4. Boron concentration in this case is approximately not lower than $1.87 \times 10^{14}$ atoms/cm$^3$ and approximately not higher than $3.18 \times 10^{15}$ atoms/cm$^3$.

In this case, a p-type silicon single crystal of which maximum value of resistivity is approximately not lower than 7.0 $\Omega$cm and approximately not higher than 168.3 $\Omega$cm, minimum value of resistivity is approximately not lower than 6.5 $\Omega$cm and approximately not higher than 150.0 $\Omega$cm, and variation in resistivity in the direction of axis of growth is approximately not higher than 17.8% can be obtained.

More preferably, a value calculated by dividing concentration of the first sub dopant in the silicon melt by concentration of the main dopant in the silicon melt (the first concentration ratio) is in a range approximately not lower than 0.79 and approximately not higher than 0.81 and a value calculated by dividing concentration of the second sub dopant in the silicon melt by concentration of the main dopant in the silicon melt (the second concentration ratio) is in a range approximately not lower than 24.2 and approximately not higher than 27.0. Boron concentration in this case is approximately not lower than $4.64 \times 10^{14}$ atoms/cm$^3$ and approximately not higher than $1.19 \times 10^{15}$ atoms/cm$^3$.

In this case, a p-type silicon single crystal of which maximum value of resistivity is approximately not lower than 21.0 $\Omega$cm and approximately not higher than 53.0 $\Omega$cm, minimum value of resistivity is approximately not lower than 20.0 $\Omega$cm and approximately not higher than 51.0 $\Omega$cm, and variation in resistivity in the direction of axis of growth is approximately not higher than 8.0% can be obtained.

More preferably, a value calculated by dividing concentration of the first sub dopant in the silicon melt by concentration of the main dopant in the silicon melt (the first concentration ratio) is in a range approximately not lower than 0.89 and approximately not higher than 0.91 and a value calculated by dividing concentration of the second sub dopant in the silicon melt by concentration of the main dopant in the silicon melt (the second concentration ratio) is in a range approximately not lower than 30.8 and approximately not higher than 33.8. Boron concentration in this case is approximately not lower than $1.94 \times 10^{14}$ atoms/cm$^3$ and approximately not higher than $2.57 \times 10^{14}$ atoms/cm$^3$.

In this case, a p-type silicon single crystal of which maximum value of resistivity is approximately not lower than 100.0 $\Omega$cm and approximately not higher than 143.1 $\Omega$cm, minimum value of resistivity is approximately not lower than 95.0 $\Omega$cm and approximately not higher than 132.1 $\Omega$cm, and variation in resistivity in the direction of axis of growth is approximately not higher than 7.9% can be obtained.

Second Embodiment

Table 2

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | P/B | Ga/B | Range of Solidified Fraction: 0-0.9 | | |
| $3.04 \times 10^{15}$ | 0.40 | 0.1 | 7.0 | 6.3 | 10.3 |
| $3.18 \times 10^{15}$ | 0.50 | 1.2 | 7.1 | 6.5 | 8.0 |
| $3.17 \times 10^{15}$ | 0.50 | 1.4 | 7.0 | 6.5 | 7.8 |
| $3.17 \times 10^{15}$ | 0.50 | 1.5 | 7.0 | 6.4 | 8.0 |
| $2.31 \times 10^{15}$ | 0.60 | 2.7 | 10.4 | 9.5 | 8.7 |
| $2.30 \times 10^{15}$ | 0.60 | 2.8 | 10.2 | 9.4 | 7.8 |
| $2.28 \times 10^{15}$ | 0.60 | 3.4 | 10.0 | 9.2 | 7.5 |
| $2.28 \times 10^{15}$ | 0.60 | 3.6 | 10.0 | 9.2 | 8.4 |
| $1.20 \times 10^{15}$ | 0.70 | 4.0 | 21.9 | 19.3 | 11.9 |
| $1.19 \times 10^{15}$ | 0.70 | 4.4 | 20.8 | 19.2 | 7.7 |
| $1.19 \times 10^{15}$ | 0.70 | 4.7 | 20.0 | 19.0 | 4.9 |
| $1.17 \times 10^{15}$ | 0.70 | 5.3 | 20.0 | 18.6 | 7.1 |
| $1.17 \times 10^{15}$ | 0.70 | 5.8 | 20.0 | 17.6 | 11.9 |
| $8.30 \times 10^{14}$ | 0.80 | 5.7 | 33.1 | 29.4 | 11.3 |
| $8.26 \times 10^{14}$ | 0.80 | 6.0 | 31.7 | 29.2 | 7.8 |
| $8.23 \times 10^{14}$ | 0.80 | 6.3 | 30.4 | 29.0 | 4.6 |
| $8.20 \times 10^{14}$ | 0.80 | 6.5 | 30.0 | 28.9 | 3.6 |
| $8.17 \times 10^{14}$ | 0.80 | 6.8 | 30.0 | 28.6 | 4.8 |
| $8.14 \times 10^{14}$ | 0.80 | 7.0 | 30.0 | 27.9 | 7.1 |
| $8.08 \times 10^{14}$ | 0.80 | 7.5 | 30.0 | 26.3 | 12.3 |

(continued)

| B Concentration (atoms/cm³) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | P/B | Ga/B | Range of Solidified Fraction: 0-0.9 | | |
| $8.08 \times 10^{14}$ | 0.79 | 6.2 | 30.5 | 29.3 | 3.9 |
| $8.08 \times 10^{14}$ | 0.81 | 6.2 | 32.4 | 30.0 | 7.4 |
| $8.08 \times 10^{14}$ | 0.79 | 6.9 | 30.1 | 27.7 | 7.8 |
| $8.08 \times 10^{14}$ | 0.81 | 6.9 | 30.5 | 29.2 | 4.2 |
| $5.23 \times 10^{14}$ | 0.90 | 7.0 | 59.3 | 49.7 | 16.3 |
| $5.17 \times 10^{14}$ | 0.90 | 7.7 | 53.1 | 49.3 | 7.1 |
| $5.15 \times 10^{14}$ | 0.90 | 7.9 | 51.6 | 49.2 | 4.7 |
| $5.12 \times 10^{14}$ | 0.90 | 8.3 | 50.0 | 48.8 | 2.4 |
| $5.11 \times 10^{14}$ | 0.90 | 8.5 | 50.0 | 47.6 | 4.9 |
| $5.09 \times 10^{14}$ | 0.90 | 8.7 | 50.0 | 46.4 | 7.3 |
| $5.07 \times 10^{14}$ | 0.90 | 9.0 | 50.0 | 44.7 | 10.6 |
| $5.07 \times 10^{14}$ | 0.89 | 7.8 | 51.6 | 49.6 | 3.9 |
| $5.07 \times 10^{14}$ | 0.91 | 7.8 | 55.1 | 50.7 | 8.0 |
| $5.07 \times 10^{14}$ | 0.89 | 8.5 | 50.0 | 46.6 | 6.9 |
| $5.07 \times 10^{14}$ | 0.91 | 8.5 | 50.7 | 49.4 | 2.7 |
| $2.72 \times 10^{14}$ | 1.00 | 9.0 | 113.9 | 99.7 | 12.4 |
| $2.70 \times 10^{14}$ | 1.00 | 9.4 | 107.1 | 99.5 | 7.1 |
| $2.69 \times 10^{14}$ | 1.00 | 9.7 | 103.5 | 99.3 | 4.0 |
| $2.67 \times 10^{14}$ | 1.00 | 10.0 | 100.7 | 97.7 | 3.0 |
| $2.67 \times 10^{14}$ | 1.00 | 10.2 | 100.0 | 95.1 | 4.9 |
| $2.66 \times 10^{14}$ | 1.00 | 10.4 | 100.0 | 92.6 | 7.4 |
| $2.63 \times 10^{14}$ | 1.00 | 11.0 | 100.0 | 85.9 | 14.1 |
| $2.20 \times 10^{14}$ | 1.10 | 10.5 | 155.1 | 130.0 | 16.2 |
| $2.18 \times 10^{14}$ | 1.10 | 11.2 | 140.4 | 129.9 | 7.4 |
| $2.16 \times 10^{14}$ | 1.10 | 11.7 | 134.3 | 127.1 | 5.4 |
| $2.15 \times 10^{14}$ | 1.10 | 12.0 | 131.6 | 121.8 | 7.4 |
| $2.13 \times 10^{14}$ | 1.10 | 12.5 | 130.0 | 113.9 | 12.4 |
| $2.00 \times 10^{14}$ | 1.20 | 12.5 | 175.2 | 150.0 | 14.4 |
| $1.98 \times 10^{14}$ | 1.20 | 13.2 | 162.0 | 150.0 | 7.4 |
| $1.97 \times 10^{14}$ | 1.20 | 13.4 | 159.5 | 146.8 | 8.0 |
| $1.95 \times 10^{14}$ | 1.20 | 14.0 | 153.3 | 134.4 | 12.3 |
| $2.08 \times 10^{14}$ | 1.30 | 15.1 | 164.9 | 146.9 | 10.9 |

Table 2 shows results of simulation of a maximum value and a minimum value of resistivity and variation in resistivity in a direction of an axis-of-growth line of the silicon single crystals when a value calculated by dividing concentration of the first sub dopant in the silicon melt by concentration of the main dopant in the silicon melt (the first concentration ratio) is varied in a range approximately not lower than 0.4 and approximately not higher than 1.3 and a value calculated by dividing concentration of the second sub dopant in the silicon melt by concentration of the main dopant in the silicon melt (the second concentration ratio) is varied in a range approximately not lower than 0.1 and approximately not higher than 15.1 in a case where boron (B), phosphorus (P), and gallium (Ga) are employed as the main dopant, the first sub dopant, and the second sub dopant to be added to the silicon melt, respectively. Boron concentration in this case is approximately not lower than $1.95 \times 10^{14}$ atoms/cm$^3$ and approximately not higher than $3.18 \times 10^{15}$ atoms/cm$^3$.

In this case, a p-type silicon single crystal of which maximum value of resistivity is approximately not lower than 7.0 $\Omega$cm and approximately not higher than 175.2 $\Omega$cm, minimum value of resistivity is approximately not lower than 6.3 $\Omega$cm and approximately not higher than 150.0 $\Omega$cm, and variation in resistivity in the direction of axis of growth is approximately not higher than 16.3% can be obtained.

More preferably, a value calculated by dividing concentration of the first sub dopant in the silicon melt by concentration of the main dopant in the silicon melt (the first concentration ratio) is in a range approximately not lower than 0.5 and approximately not higher than 1.2 and a value calculated by dividing concentration of the second sub dopant in the silicon melt by concentration of the main dopant in the silicon melt (the second concentration ratio) is in a range approximately not lower than 1.2 and approximately not higher than 13.4. Boron concentration in this case is approximately not lower than $1.97 \times 10^{14}$ atoms/cm$^3$ and approximately not higher than $3.18 \times 10^{15}$ atoms/cm$^3$.

In this case, a p-type silicon single crystal of which maximum value of resistivity is approximately not lower than 7.0 $\Omega$cm and approximately not higher than 175.2 $\Omega$cm, minimum value of resistivity is approximately not lower than 6.5 $\Omega$cm and approximately not higher than 150.0 $\Omega$cm, and variation in resistivity in the direction of axis of growth is approximately not higher than 16.3% can be obtained.

More preferably, a value calculated by dividing concentration of the first sub dopant in the silicon melt by concentration of the main dopant in the silicon melt (the first concentration ratio) is in a range approximately not lower than 0.79 and approximately not higher than 0.81 and a value calculated by dividing concentration of the second sub dopant in the silicon melt by concentration of the main dopant in the silicon melt (the second concentration ratio) is in a range approximately not lower than 6.2 and approximately not higher than 6.9. Boron concentration in this case is approximately not lower than $8.08 \times 10^{14}$ atoms/cm$^3$ and approximately not higher than $8.23 \times 10^{14}$ atoms/cm$^3$.

In this case, a p-type silicon single crystal of which maximum value of resistivity is approximately not lower than 30.0 $\Omega$cm and approximately not higher than 32.4 $\Omega$cm, minimum value of resistivity is approximately not lower than 28.6 $\Omega$cm and approximately not higher than 30.0 $\Omega$cm, and variation in resistivity in the direction of axis of growth is approximately not higher than 7.8% can be obtained.

More preferably, a value calculated by dividing concentration of the first sub dopant in the silicon melt by concentration of the main dopant in the silicon melt (the first concentration ratio) is in a range approximately not lower than 0.89 and approximately not higher than 0.91 and a value calculated by dividing concentration of the second sub dopant in the silicon melt by concentration of the main dopant in the silicon melt (the second concentration ratio) is in a range approximately not lower than 7.8 and approximately not higher than 8.5. Boron concentration in this case is approximately not lower than $5.07 \times 10^{14}$ atoms/cm$^3$ and approximately not higher than $5.15 \times 10^{14}$ atoms/cm$^3$.

In this case, a p-type silicon single crystal of which maximum value of resistivity is approximately not lower than 50.0 $\Omega$cm and approximately not higher than 55.1 $\Omega$cm, minimum value of resistivity is approximately not lower than 47.6 $\Omega$cm and approximately not higher than 50.7 $\Omega$cm, and variation in resistivity in the direction of axis of growth is approximately not higher than 8.0% can be obtained.

Third Embodiment

Table 3

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | P/B | In/B | Range of Solidified Fraction: 0-0.9 | | |
| $3.28 \times 10^{15}$ | 0.50 | 25.1 | 6.8 | 6.3 | 7.5 |
| $3.41 \times 10^{15}$ | 0.60 | 58.7 | 6.8 | 6.4 | 6.2 |
| $3.59 \times 10^{15}$ | 0.70 | 78.0 | 7.5 | 6.6 | 11.9 |
| $4.73 \times 10^{14}$ | 0.70 | 86.0 | 52.1 | 48.0 | 7.8 |
| $4.71 \times 10^{14}$ | 0.70 | 92.3 | 50.0 | 47.6 | 4.9 |
| $4.67 \times 10^{14}$ | 0.70 | 105.0 | 50.0 | 46.2 | 7.6 |

(continued)

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | P/B | In/B | Range of Solidified Fraction: 0-0.9 | | |
| $2.32 \times 10^{14}$ | 0.70 | 110.0 | 100.0 | 89.8 | 10.2 |
| $2.69 \times 10^{14}$ | 1.00 | 194.2 | 101.7 | 99.1 | 2.5 |
| $2.87 \times 10^{14}$ | 1.10 | 210.0 | 115.4 | 100.0 | 13.3 |
| $2.19 \times 10^{14}$ | 1.10 | 220.0 | 140.5 | 130.0 | 7.5 |
| $2.17 \times 10^{14}$ | 1.10 | 226.8 | 136.1 | 129.7 | 4.7 |
| $2.16 \times 10^{14}$ | 1.10 | 235.0 | 132.2 | 122.1 | 7.7 |
| $2.15 \times 10^{14}$ | 1.10 | 240.0 | 130.4 | 117.9 | 9.6 |
| $1.98 \times 10^{14}$ | 1.20 | 261.2 | 161.3 | 148.8 | 7.8 |
| $2.10 \times 10^{14}$ | 1.30 | 291.3 | 169.4 | 150.0 | 11.5 |

Table 3 shows results of simulation of a maximum value and a minimum value of resistivity and variation in resistivity in a direction of an axis-of-growth line of the silicon single crystals when a value calculated by dividing concentration of the first sub dopant in the silicon melt by concentration of the main dopant in the silicon melt (the first concentration ratio) is varied in a range approximately not lower than 0.5 and approximately not higher than 1.3 and a value calculated by dividing concentration of the second sub dopant in the silicon melt by concentration of the main dopant in the silicon melt (the second concentration ratio) is varied in a range approximately not lower than 25.1 and approximately not higher than 291.3 in a case where boron (B), phosphorus (P), and indium (In) are employed as the main dopant, the first sub dopant, and the second sub dopant to be added to the silicon melt, respectively. Boron concentration in this case is approximately not lower than $1.98 \times 10^{14}$ atoms/cm$^3$ and approximately not higher than $3.59 \times 10^{15}$ atoms/cm$^3$.

In this case, a p-type silicon single crystal of which maximum value of resistivity is approximately not lower than 6.8 $\Omega$cm and approximately not higher than 169.4 $\Omega$cm, minimum value of resistivity is approximately not lower than 6.3 $\Omega$cm and approximately not higher than 150.0 $\Omega$cm, and variation in resistivity in the direction of axis of growth is approximately not higher than 13.3% can be obtained.

More preferably, a value calculated by dividing concentration of the first sub dopant in the silicon melt by concentration of the main dopant in the silicon melt (the first concentration ratio) is in a range approximately not lower than 0.5 and approximately not higher than 1.2 and a value calculated by dividing concentration of the second sub dopant in the silicon melt by concentration of the main dopant in the silicon melt (the second concentration ratio) is in a range approximately not lower than 25.1 and approximately not higher than 261.2. Boron concentration in this case is approximately not lower than $1.98 \times 10^{14}$ atoms/cm$^3$ and approximately not higher than $3.59 \times 10^{15}$ atoms/cm$^3$.

In this case, a p-type silicon single crystal of which maximum value of resistivity is approximately not lower than 6.8 $\Omega$cm and approximately not higher than 161.3 $\Omega$cm, minimum value of resistivity is approximately not lower than 6.3 $\Omega$cm and approximately not higher than 148.8 $\Omega$cm, and variation in resistivity in the direction of axis of growth is approximately not higher than 13.3% can be obtained.

Fourth Embodiment

Table 4

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | As/B | Al/B | Range of Solidified Fraction: 0-0.9 | | |
| $3.01 \times 10^{15}$ | 0.50 | 5.0 | 7.0 | 6.4 | 8.6 |
| $3.09 \times 10^{15}$ | 0.60 | 11.7 | 7.0 | 6.5 | 7.6 |
| $3.51 \times 10^{15}$ | 1.00 | 34.0 | 8.2 | 6.9 | 15.7 |

(continued)

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | As/B | Al/B | Range of Solidified Fraction: 0-0.9 | | |
| $4.75 \times 10^{14}$ | 1.00 | 37.0 | 52.5 | 48.7 | 7.3 |
| $4.72 \times 10^{14}$ | 1.00 | 38.5 | 50.0 | 48.3 | 3.4 |
| $4.68 \times 10^{14}$ | 1.00 | 41.0 | 50.0 | 46.3 | 7.4 |
| $2.35 \times 10^{14}$ | 1.00 | 43.0 | 98.4 | 86.1 | 12.5 |
| $2.42 \times 10^{14}$ | 1.10 | 45.4 | 100.0 | 97.6 | 2.4 |
| $2.50 \times 10^{14}$ | 1.30 | 54.0 | 126.3 | 105.2 | 16.7 |
| $2.50 \times 10^{14}$ | 1.30 | 57.0 | 111.8 | 103.6 | 7.3 |
| $2.50 \times 10^{14}$ | 1.30 | 58.9 | 105.8 | 102.3 | 3.3 |
| $2.50 \times 10^{14}$ | 1.30 | 61.0 | 102.4 | 94.6 | 7.6 |
| $1.69 \times 10^{14}$ | 1.30 | 64.0 | 150.0 | 126.6 | 15.6 |
| $1.84 \times 10^{14}$ | 1.50 | 72.2 | 160.7 | 149.3 | 7.1 |
| $1.91 \times 10^{14}$ | 1. 60 | 78.6 | 165.6 | 150.0 | 9.4 |

Table 4 shows results of simulation of a maximum value and a minimum value of resistivity and variation in resistivity in a direction of an axis-of-growth line of the silicon single crystals when a value calculated by dividing concentration of the first sub dopant in the silicon melt by concentration of the main dopant in the silicon melt (the first concentration ratio) is varied in a range approximately not lower than 0.5 and approximately not higher than 1.6 and a value calculated by dividing concentration of the second sub dopant in the silicon melt by concentration of the main dopant in the silicon melt (the second concentration ratio) is varied in a range approximately not lower than 5.0 and approximately not higher than 78.6 in a case where boron (B), arsenic (As), and aluminum (Al) are employed as the main dopant, the first sub dopant, and the second sub dopant to be added to the silicon melt, respectively. Boron concentration in this case is approximately not lower than $1.69 \times 10^{14}$ atoms/cm$^3$ and approximately not higher than $3.51 \times 10^{15}$ atoms/cm$^3$.

In this case, a p-type silicon single crystal of which maximum value of resistivity is approximately not lower than 7.0 $\Omega$cm and approximately not higher than 165.6 $\Omega$cm, minimum value of resistivity is approximately not lower than 6.4 $\Omega$cm and approximately not higher than 150.0 $\Omega$cm, and variation in resistivity in the direction of axis of growth is approximately not higher than 16.7% can be obtained.

More preferably, a value calculated by dividing concentration of the first sub dopant in the silicon melt by concentration of the main dopant in the silicon melt (the first concentration ratio) is in a range approximately not lower than 0.6 and approximately not higher than 1.5 and a value calculated by dividing concentration of the second sub dopant in the silicon melt by concentration of the main dopant in the silicon melt (the second concentration ratio) is in a range approximately not lower than 11.7 and approximately not higher than 72.2. Boron concentration in this case is approximately not lower than $1.69 \times 10^{14}$ atoms/cm$^3$ and approximately not higher than $3.51 \times 10^{15}$ atoms/cm$^3$.

In this case, a p-type silicon single crystal of which maximum value of resistivity is approximately not lower than 7.0 $\Omega$cm and approximately not higher than 160.7 $\Omega$cm, minimum value of resistivity is approximately not lower than 6.5 $\Omega$cm and approximately not higher than 149.3 $\Omega$cm, and variation in resistivity in the direction of axis of growth is approximately not higher than 16.7% can be obtained.

Fifth Embodiment

Table 5

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | As/B | Ga/B | Range of Solidified Fraction: 0-0.9 | | |
| $3.08 \times 10^{15}$ | 0.60 | 3.1 | 7.0 | 6.4 | 8.0 |
| $3.16 \times 10^{15}$ | 0.70 | 4.8 | 7.0 | 6.5 | 7.0 |
| $3.40 \times 10^{15}$ | 0.90 | 7.0 | 8.0 | 6.8 | 15.2 |
| $4.59 \times 10^{14}$ | 0.90 | 7.8 | 51.7 | 48.0 | 7.1 |
| $4.57 \times 10^{14}$ | 0.90 | 8.2 | 50.0 | 47.5 | 5.0 |
| $4.54 \times 10^{14}$ | 0.90 | 8.7 | 50.0 | 46.4 | 7.2 |
| $4.49 \times 10^{14}$ | 0.90 | 9.4 | 50.0 | 43.1 | 13.8 |
| $2.49 \times 10^{14}$ | 1.20 | 13.3 | 100.2 | 98.3 | 1.8 |
| $2.57 \times 10^{14}$ | 1.30 | 13.5 | 127.2 | 102.2 | 19.7 |
| $2.57 \times 10^{14}$ | 1.30 | 14.4 | 109.0 | 100.4 | 7.9 |
| $2.57 \times 10^{14}$ | 1.30 | 14.9 | 102.5 | 99.3 | 3.2 |
| $2.57 \times 10^{14}$ | 1.30 | 15.5 | 99.1 | 91.4 | 7.7 |
| $1.69 \times 10^{14}$ | 1.30 | 16.0 | 150.0 | 130.3 | 13.1 |
| $1.83 \times 10^{14}$ | 1.50 | 18.3 | 160.3 | 150.0 | 6.4 |
| $1.90 \times 10^{14}$ | 1. 60 | 19.9 | 165.4 | 150.0 | 9.3 |

Table 5 shows results of simulation of a maximum value and a minimum value of resistivity and variation in resistivity in a direction of an axis-of-growth line of the silicon single crystals when a value calculated by dividing concentration of the first sub dopant in the silicon melt by concentration of the main dopant in the silicon melt (the first concentration ratio) is varied in a range approximately not lower than 0.6 and approximately not higher than 1.6 and a value calculated by dividing concentration of the second sub dopant in the silicon melt by concentration of the main dopant in the silicon melt (the second concentration ratio) is varied in a range approximately not lower than 3.1 and approximately not higher than 19.9 in a case where boron (B), arsenic (As), and gallium (Ga) are employed as the main dopant, the first sub dopant, and the second sub dopant to be added to the silicon melt, respectively. Boron concentration in this case is approximately not lower than $1.69 \times 10^{14}$ atoms/cm$^3$ and approximately not higher than $3.40 \times 10^{15}$ atoms/cm$^3$.

In this case, a p-type silicon single crystal of which maximum value of resistivity is approximately not lower than 7.0 Ωcm and approximately not higher than 165.4 Ωcm, minimum value of resistivity is approximately not lower than 6.4 Ωcm and approximately not higher than 150.0 Ωcm, and variation in resistivity in the direction of axis of growth is approximately not higher than 19.7% can be obtained.

More preferably, a value calculated by dividing concentration of the first sub dopant in the silicon melt by concentration of the main dopant in the silicon melt (the first concentration ratio) is in a range approximately not lower than 0.6 and approximately not higher than 1.5 and a value calculated by dividing concentration of the second sub dopant in the silicon melt by concentration of the main dopant in the silicon melt (the second concentration ratio) is in a range approximately not lower than 3.1 and approximately not higher than 18.3. Boron concentration in this case is approximately not lower than $1.69 \times 10^{14}$ atoms/cm$^3$ and approximately not higher than $3.40 \times 10^{15}$ atoms/cm$^3$.

In this case, a p-type silicon single crystal of which maximum value of resistivity is approximately not lower than 7.0 Ωcm and approximately not higher than 160.3 Ωcm, minimum value of resistivity is approximately not lower than 6.5 Ωcm and approximately not higher than 150.0 Ωcm, and variation in resistivity in the direction of axis of growth is approximately not higher than 19.7% can be obtained.

Sixth Embodiment

Table 6

| B Concentration (atoms/cm$^3$) Initial Si Melt | Dopant Ratio (Initial Si Melt) | | Maximum Value of Resistivity (ohm cm) | Minimum Value of Resistivity (ohm cm) | Variation in Resistivity in Direction of Axis (%) |
|---|---|---|---|---|---|
| | As/B | In/B | Range of Solidified Fraction: 0-0.9 | | |
| $3.01\times10^{15}$ | 0.50 | 24.4 | 7.0 | 6.4 | 8.5 |
| $3.09\times10^{15}$ | 0.60 | 57.9 | 7.0 | 6.5 | 7.6 |
| $3.40\times10^{15}$ | 0.90 | 140.0 | 7.9 | 6.8 | 13.7 |
| $4.61\times10^{14}$ | 0.90 | 152.0 | 52.0 | 48.1 | 7.5 |
| $4.59\times10^{14}$ | 0.90 | 158.1 | 50.0 | 47.8 | 4.5 |
| $4.54\times10^{14}$ | 0.90 | 172.0 | 50.0 | 46.1 | 7.9 |
| $2.24\times10^{14}$ | 0.90 | 186.0 | 100.0 | 85.4 | 14.6 |
| $2.42\times10^{14}$ | 1.10 | 226.6 | 100.0 | 97.6 | 2.4 |
| $2.64\times10^{14}$ | 1.30 | 265.0 | 124.3 | 100.0 | 19.6 |
| $2.60\times10^{14}$ | 1.30 | 283.0 | 108.1 | 99.7 | 7.8 |
| $2.59\times10^{14}$ | 1.30 | 292.2 | 103.0 | 99.4 | 3.5 |
| $2.56\times10^{14}$ | 1.30 | 304.0 | 100.0 | 92.2 | 7.7 |
| $1.69\times10^{14}$ | 1.30 | 315.0 | 150.0 | 129.3 | 13.8 |
| $1.78\times10^{14}$ | 1.40 | 324.0 | 158.5 | 149.8 | 5.5 |
| $1.91\times10^{14}$ | 1. 60 | 391.6 | 165.7 | 150.0 | 9.5 |

Table 6 shows results of simulation of a maximum value and a minimum value of resistivity and variation in resistivity in a direction of an axis-of-growth line of the silicon single crystals when a value calculated by dividing concentration of the first sub dopant in the silicon melt by concentration of the main dopant in the silicon melt (the first concentration ratio) is varied in a range approximately not lower than 0.5 and approximately not higher than 1.6 and a value calculated by dividing concentration of the second sub dopant in the silicon melt by concentration of the main dopant in the silicon melt (the second concentration ratio) is varied in a range approximately not lower than 24.4 and approximately not higher than 391.6 in a case where boron (B), arsenic (As), and indium (In) are employed as the main dopant, the first sub dopant, and the second sub dopant to be added to the silicon melt, respectively. Boron concentration in this case is approximately not lower than $1.69 \times 10^{14}$ atoms/cm$^3$ and approximately not higher than $3.40 \times 10^{15}$ atoms/cm$^3$.

In this case, a p-type silicon single crystal of which maximum value of resistivity is approximately not lower than 7.0 $\Omega$cm and approximately not higher than 165.7 $\Omega$cm, minimum value of resistivity is approximately not lower than 6.4 $\Omega$cm and approximately not higher than 150.0 $\Omega$cm, and variation in resistivity in the direction of axis of growth is approximately not higher than 19.6% can be obtained.

More preferably, a value calculated by dividing concentration of the first sub dopant in the silicon melt by concentration of the main dopant in the silicon melt (the first concentration ratio) is in a range approximately not lower than 0.6 and approximately not higher than 1.4 and a value calculated by dividing concentration of the second sub dopant in the silicon melt by concentration of the main dopant in the silicon melt (the second concentration ratio) is in a range approximately not lower than 57.9 and approximately not higher than 324.0. Boron concentration in this case is approximately not lower than $1.69 \times 10^{14}$ atoms/cm$^3$ and approximately not higher than $3.40 \times 10^{15}$ atoms/cm$^3$.

In this case, a p-type silicon single crystal of which maximum value of resistivity is approximately not lower than 7.0 $\Omega$cm and approximately not higher than 158.5 $\Omega$cm, minimum value of resistivity is approximately not lower than 6.5 $\Omega$cm and approximately not higher than 149.8 $\Omega$cm, and variation in resistivity in the direction of axis of growth is approximately not higher than 19.6% can be obtained.

As described above, the p-type silicon single crystal grown with the Czochralski method from the initial silicon melt to which boron (the main dopant), the first sub dopant which is an n-type impurity and smaller in segregation coefficient than boron, and the second sub dopant which is a p-type impurity and smaller in segregation coefficient than the first sub dopant have been added contains boron (the main dopant), the first sub dopant which is an n-type impurity and smaller in segregation coefficient than boron, and the second sub dopant which is a p-type impurity and smaller in segregation coefficient than the first sub dopant. Then, on condition that the first concentration ratio calculated by dividing concentration of the first sub dopant in the silicon melt by concentration of the main dopant in the silicon melt and the second concentration ratio calculated by dividing concentration of the second sub dopant in the silicon melt by concentration of the main dopant in the silicon melt are in the ranges described in the first to sixth embodiments, the p-type silicon single crystal containing the main dopant, the first sub dopant, and the second sub dopant at the first concentration ratio and the second concentration ratio in that range can be obtained.

A method of measuring concentration of a dopant contained in silicon single crystal 1 will now be described. Concentration of such an element as boron, phosphorus, aluminum, gallium, indium, and arsenic as a dopant in silicon single crystal 1 can be measured with such a known method as SIMS (Secondary Ion Mass Spectroscopy).

It should be understood that the embodiments disclosed herein are illustrative and non-restrictive in every respect. The scope of the present invention is defined by the terms of the claims, rather than the embodiments and examples above, and is intended to include any modifications within the scope and meaning equivalent to the terms of the claims.

## Claims

1. A method of manufacturing a p-type silicon single crystal, comprising the steps of:

   - preparing a silicon melt to which boron as a main dopant, a first sub dopant which is an n-type impurity and smaller in segregation coefficient than said boron, and a second sub dopant which is a p-type impurity and smaller in segregation coefficient than said first sub dopant have been added; and
   - growing a silicon single crystal having resistivity not lower than 6 $\Omega$cm from said silicon melt with a Czochralski method, wherein either
   - said first sub dopant is phosphorus and said second sub dopant is aluminum, and
   - a first concentration ratio calculated by dividing concentration of said first sub dopant in said silicon melt by concentration of said main dopant in said silicon melt is not lower than 0.5 and not higher than 1.2 and a second concentration ratio calculated by dividing concentration of said second sub dopant in said silicon melt by concentration of said main dopant in said silicon melt is not lower than 4.9 and not higher than 52.4, or wherein
   - said first sub dopant is phosphorus and said second sub dopant is gallium, and
   - a first concentration ratio calculated by dividing concentration of said first sub dopant in said silicon melt by concentration of said main dopant in said silicon melt is not lower than 0.5 and not higher than 1.2 and a second concentration ratio calculated by dividing concentration of said second sub dopant in said silicon melt by concentration of said main dopant in said silicon melt is not lower than 1.2 and not higher than 13.4, or wherein
   - said first sub dopant is phosphorus and said second sub dopant is indium, and
   - a first concentration ratio calculated by dividing concentration of said first sub dopant in said silicon melt by concentration of said main dopant in said silicon melt is not lower than 0.5 and not higher than 1.2 and a second concentration ratio calculated by dividing concentration of said second sub dopant in said silicon melt by concentration of said main dopant in said silicon melt is not lower than 25.1 and not higher than 261.2, or wherein
   - said first sub dopant is arsenic and said second sub dopant is aluminum, and
   - a first concentration ratio calculated by dividing concentration of said first sub dopant in said silicon melt by concentration of said main dopant in said silicon melt is not lower than 0.6 and not higher than 1.5 and a second concentration ratio calculated by dividing concentration of said second sub dopant in said silicon melt by concentration of said main dopant in said silicon melt is not lower than 11.7 and not higher than 72.2, or wherein
   - said first sub dopant is arsenic and said second sub dopant is gallium, and
   - a first concentration ratio calculated by dividing concentration of said first sub dopant in said silicon melt by concentration of said main dopant in said silicon melt is not lower than 0.6 and not higher than 1.5 and a second concentration ratio calculated by dividing concentration of said second sub dopant in said silicon melt by concentration of said main dopant in said silicon melt is not lower than 3.1 and not higher than 18.3, or wherein
   - said first sub dopant is arsenic and said second sub dopant is indium, and
   - a first concentration ratio calculated by dividing concentration of said first sub dopant in said silicon melt by concentration of said main dopant in said silicon melt is not lower than 0.6 and not higher than 1.4 and a second concentration ratio calculated by dividing concentration of said second sub dopant in said silicon melt by concentration of said main dopant in said silicon melt is not lower than 57.9 and not higher than 324.0.

2. The method of manufacturing a p-type silicon single crystal according to claim 1, wherein

   - in case that the first sub dopant is phosphorus and the second sub dopant is aluminum, then

- a first concentration ratio calculated by dividing concentration of said first sub dopant in said silicon melt by concentration of said main dopant in said silicon melt is not lower than 0.79 and not higher than 0.81 and a second concentration ratio calculated by dividing concentration of said second sub dopant in said silicon melt by concentration of said main dopant in said silicon melt is not lower than 24.2 and not higher than 27.0.

3. The method of manufacturing a p-type silicon single crystal according to claim 1, wherein

- in case that the first sub dopant is phosphorus and the second sub dopant is aluminum, then
- a first concentration ratio calculated by dividing concentration of said first sub dopant in said silicon melt by concentration of said main dopant in said silicon melt is not lower than 0.89 and not higher than 0.91 and a second concentration ratio calculated by dividing concentration of said second sub dopant in said silicon melt by concentration of said main dopant in said silicon melt is not lower than 30.8 and not higher than 33.8.

4. The method of manufacturing a p-type silicon single crystal according to claim 1, wherein

- in case that the first sub dopant is phosphorus and the second sub dopant is gallium, then
- a first concentration ratio calculated by dividing concentration of said first sub dopant in said silicon melt by concentration of said main dopant in said silicon melt is not lower than 0.79 and not higher than 0.81 and a second concentration ratio calculated by dividing concentration of said second sub dopant in said silicon melt by concentration of said main dopant in said silicon melt is not lower than 6.2 and not higher than 6.9.

5. The method of manufacturing a p-type silicon single crystal according to claim 1, wherein

- in case that the first sub dopant is phosphorus and the second sub dopant is gallium, then
- a first concentration ratio calculated by dividing concentration of said first sub dopant in said silicon melt by concentration of said main dopant in said silicon melt is not lower than 0.89 and not higher than 0.91 and a second concentration ratio calculated by dividing concentration of said second sub dopant in said silicon melt by concentration of said main dopant in said silicon melt is not lower than 7.8 and not higher than 8.5.

**Patentansprüche**

1. Verfahren zum Herstellen eines Siliziumeinkristalls vom p-Typ, umfassend die folgenden Schritte:

- Herstellen einer Siliziumschmelze, zu dem Bor als ein Hauptdotierstoff, ein erster Unterdotierstoff, der eine Störstelle vom n-Typ ist und einen kleineren Segregationskoeffizienten als das Bor besitzt, und ein zweiter Unterdotierstoff, der eine Störstelle vom p-Typ ist und einen kleineren Segregationskoeffizienten als der erste Unterdotierstoff besitzt, zugesetzt worden sind; und
- Aufwachsen eines Siliziumeinkristalls mit einem spezifischen Widerstand von mindestens 6 $\Omega$cm aus der Siliziumschmelze mit einem Czochralski-Verfahren, wobei entweder
- der erste Unterdotierstoff Phosphor ist und der zweite Unterdotierstoff Aluminium ist, und
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,5 und höchstens 1,2 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 4,9 und höchstens 52,4 beträgt, oder wobei
- der erste Unterdotierstoff Phosphor ist und der zweite Unterdotierstoff Gallium ist, und
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,5 und höchstens 1,2 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 1,2 und höchstens 13,4 beträgt, oder wobei
- der erste Unterdotierstoff Phosphor ist und der zweite Unterdotiertstoff Indium ist, und
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,5 und höchstens 1,2 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 25,1 und höchstens 261,2 beträgt, oder wobei

- der erste Unterdotierstoff Arsen ist und der zweite Unterdotierstoff Aluminium ist, und
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,6 und höchstens 1,5 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 11,7 und höchstens 72,2 beträgt, oder wobei
- der erste Unterdotierstoff Arsen ist und der zweite Unterdotierstoff Gallium ist, und
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,6 und höchstens 1,5 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 3,1 und höchstens 18,3 beträgt, oder wobei
- der erste Unterdotierstoff Arsen ist und der zweite Unterdotierstoff Indium ist, und
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,6 und höchstens 1,4 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 57,9 und höchstens 324,0 beträgt.

2. Verfahren zum Herstellen eines Siliziumeinkristalls vom p-Typ nach Anspruch 1, wobei

- falls der erste Unterdotierstoff Phosphor ist und der zweite Unterdotierstoff Aluminium ist, dann
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,79 und höchstens 0,81 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 24,2 und höchstens 27,0 beträgt.

3. Verfahren zum Herstellen eines Siliziumeinkristalls vom p-Typ nach Anspruch 1, wobei

- falls der erste Unterdotierstoff Phosphor ist und der zweite Unterdotierstoff Aluminium ist, dann
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,89 und höchstens 0,91 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 30,8 und höchstens 33,8 beträgt.

4. Verfahren zum Herstellen eines Siliziumeinkristalls vom p-Typ nach Anspruch 1, wobei

- falls der erste Unterdotierstoff Phosphor ist und der zweite Unterdotierstoff Gallium ist, dann
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,79 und höchstens 0,81 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 6,2 und höchstens 6,9 beträgt.

5. Verfahren zum Herstellen eines Siliziumeinkristalls vom p-Typ nach Anspruch 1, wobei

- falls der erste Unterdotierstoff Phosphor ist und der zweite Unterdotierstoff Gallium ist, dann
- ein erstes Konzentrationsverhältnis, berechnet durch Dividieren der Konzentration des ersten Unterdotierstoffs in der Siliziumschmelze durch die Konzentration des Hauptdotierstoffs in der Siliziumschmelze, mindestens 0,89 und höchstens 0,91 beträgt, und ein zweites Konzentrationsverhältnis, berechnet durch Dividieren der Konzentration des zweiten Unterdotierstoffs in der Siliziumschmelze durch die Konzentration des Hauptdotierstoffs in der Siliziumschmelze, mindestens 7,8 und höchstens 8,5 beträgt.

**Revendications**

1. Procédé de fabrication d'un monocristal de silicium de type p, comprenant les étapes consistant à :

- préparer une masse fondue de silicium à laquelle du bore en tant que dopant principal, un premier sous-dopant qui est une impureté de type n et qui a un coefficient de ségrégation plus petit que celui dudit bore et un second sous-dopant qui est une impureté de type p et qui a un coefficient de ségrégation plus petit que celui dudit premier sous-dopant ont été ajoutés ;
- faire croître un monocristal de silicium ayant une résistivité supérieure ou égale à 6 Ωcm à partir de ladite masse fondue de silicium avec un procédé de Czochralski,

dans lequel soit

- ledit premier sous-dopant est le phosphore et ledit second sous-dopant est l'aluminium et
- un premier rapport de concentrations calculé par division de la concentration dudit premier sous-dopant dans ladite masse fondue de silicium par la concentration dudit dopant principal dans ladite masse fondue de silicium est supérieur ou égal à 0,5 et inférieur ou égal à 1,2 et un second rapport de concentrations calculé par division de la concentration dudit second sous-dopant dans ladite masse fondue de silicium par la concentration dudit dopant principal dans ladite masse fondue de silicium est supérieur ou égal à 4,9 et inférieur ou égal à 52,4,

soit

- ledit premier sous-dopant est le phosphore et ledit second sous-dopant est le gallium et
- un premier rapport de concentrations calculé par division de la concentration dudit premier sous-dopant dans ladite masse fondue de silicium par la concentration dudit dopant principal dans ladite masse fondue de silicium est supérieur ou égal à 0,5 et inférieur ou égal à 1,2 et un second rapport de concentrations calculé par division de la concentration dudit second sous-dopant dans ladite masse fondue de silicium par la concentration dudit dopant principal dans ladite masse fondue de silicium est supérieur ou égal à 1,2 et inférieur ou égal à 13,4,

soit

- ledit premier sous-dopant est le phosphore et ledit second sous-dopant est l'indium et
- un premier rapport de concentrations calculé par division de la concentration dudit premier sous-dopant dans ladite masse fondue de silicium par la concentration dudit dopant principal dans ladite masse fondue de silicium est supérieur ou égal à 0,5 et inférieur ou égal à 1,2 et un second rapport de concentrations calculé par division de la concentration dudit second sous-dopant dans ladite masse fondue de silicium par la concentration dudit dopant principal dans ladite masse fondue de silicium est supérieur ou égal à 25,1 et inférieur ou égal à 261,2,

soit

- ledit premier sous-dopant est l'arsenic et ledit second sous-dopant est l'aluminium et
- un premier rapport de concentrations calculé par division de la concentration dudit premier sous-dopant dans ladite masse fondue de silicium par la concentration dudit dopant principal dans ladite masse fondue de silicium est supérieur ou égal à 0,6 et inférieur ou égal à 1,5 et un second rapport de concentrations calculé par division de la concentration dudit second sous-dopant dans ladite masse fondue de silicium par la concentration dudit dopant principal dans ladite masse fondue de silicium est supérieur ou égal à 11,7 et inférieur ou égal à 72,2,

soit

- ledit premier sous-dopant est l'arsenic et ledit second sous-dopant est le gallium et
- un premier rapport de concentrations calculé par division de la concentration dudit premier sous-dopant dans ladite masse fondue de silicium par la concentration dudit dopant principal dans ladite masse fondue de silicium est supérieur ou égal à 0,6 et inférieur ou égal à 1,5 et un second rapport de concentrations calculé par division de la concentration dudit second sous-dopant dans ladite masse fondue de silicium par la concentration dudit dopant principal dans ladite masse fondue de silicium est supérieur ou égal à 3,1 et inférieur ou égal à 18,3,

soit

- ledit premier sous-dopant est l'arsenic et ledit second sous-dopant est l'indium et
- un premier rapport de concentrations calculé par division de la concentration dudit premier sous-dopant dans ladite masse fondue de silicium par la concentration dudit dopant principal dans ladite masse fondue de silicium est supérieur ou égal à 0,6 et inférieur ou égal à 1,4 et un second rapport de concentrations calculé par division de la concentration dudit second sous-dopant dans ladite masse fondue de silicium par la concentration dudit dopant principal dans ladite masse fondue de silicium est supérieur ou égal à 57,9 et inférieur ou égal à 324,0.

2. Procédé de fabrication d'un monocristal de silicium de type p selon la revendication 1, dans lequel

- dans le cas où le premier sous-dopant est le phosphore et le second sous-dopant est l'aluminium, alors
- un premier rapport de concentrations calculé par division de la concentration dudit premier sous-dopant dans ladite masse fondue de silicium par la concentration dudit dopant principal dans ladite masse fondue de silicium est supérieur ou égal à 0,79 et inférieur ou égal à 0,81 et un second rapport de concentrations calculé par division de la concentration dudit second sous-dopant dans ladite masse fondue de silicium par la concentration dudit dopant principal dans ladite masse fondue de silicium est supérieur ou égal à 24,2 et inférieur ou égal à 27,0.

3. Procédé de fabrication d'un monocristal de silicium de type p selon la revendication 1, dans lequel

- dans le cas où le premier sous-dopant est le phosphore et le second sous-dopant est l'aluminium, alors
- un premier rapport de concentrations calculé par division de la concentration dudit premier sous-dopant dans ladite masse fondue de silicium par la concentration dudit dopant principal dans ladite masse fondue de silicium est supérieur ou égal à 0,89 et inférieur ou égal à 0,91 et un second rapport de concentrations calculé par division de la concentration dudit second sous-dopant dans ladite masse fondue de silicium par la concentration dudit dopant principal dans ladite masse fondue de silicium est supérieur ou égal à 30,8 et inférieur ou égal à 33,8.

4. Procédé de fabrication d'un monocristal de silicium de type p selon la revendication 1, dans lequel

- dans le cas où le premier sous-dopant est le phosphore et le second sous-dopant est le gallium, alors
- un premier rapport de concentrations calculé par division de la concentration dudit premier sous-dopant dans ladite masse fondue de silicium par la concentration dudit dopant principal dans ladite masse fondue de silicium est supérieur ou égal à 0,79 et inférieur ou égal à 0,81 et un second rapport de concentrations calculé par division de la concentration dudit second sous-dopant dans ladite masse fondue de silicium par la concentration dudit dopant principal dans ladite masse fondue de silicium est supérieur ou égal à 6,2 et inférieur ou égal à 6,9.

5. Procédé de fabrication d'un monocristal de silicium de type p selon la revendication 1, dans lequel

- dans le cas où le premier sous-dopant est le phosphore et le second sous-dopant est le gallium, alors
- un premier rapport de concentrations calculé par division de la concentration dudit premier sous-dopant dans ladite masse fondue de silicium par la concentration dudit dopant principal dans ladite masse fondue de silicium est supérieur ou égal à 0,89 et inférieur ou égal à 0,91 et un second rapport de concentrations calculé par division de la concentration dudit second sous-dopant dans ladite masse fondue de silicium par la concentration dudit dopant principal dans ladite masse fondue de silicium est supérieur ou égal à 7,8 et inférieur ou égal à 8,5.

# Fig. 1

## Fig. 2

```
┌─────────────────────────────┐
│   SILICON MELT PREPARATION  │──── S1
│            STEP             │
└─────────────────────────────┘
              │
              ▼
┌─────────────────────────────┐
│   SILICON SINGLE CRYSTAL    │──── S2
│        GROWTH STEP          │
└─────────────────────────────┘
              │
              ▼
┌─────────────────────────────┐
│   SILICON SINGLE CRYSTAL    │──── S3
│        CUTTING STEP         │
└─────────────────────────────┘
```

## Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010531805 A